# EUROPEAN PATENT APPLICATION

(11) **EP 4 572 039 A1**
(43) Date of publication of application: **18.06.2025**
(21) Application number: 23307208.1
(22) Date of filing: 14.12.2023
(51) Int. Cl.: H01S 5/02, H01S 5/026, H01S 5/10, H01S 5/227, H01S 5/22, H01S 5/323

(54) **SEMI-INULATING HIGH INDEX SPOT SIZE CONVERTER FOR OPTICAL COUPLING OF III-V ON SILICON HETEROINTEGRATED CIRCUITS**

(71) Applicant: Nokia Solutions and Networks Oy, 02610 Espoo (FI)
(72) Inventor: CAILLAUD, Christophe, 94110 Arcueil (FR); BESANCON, Claire, 75014 Paris (FR); BITAULD, David, 91300 Massy (FR)
(74) Representative: Novagraaf Technologies

(57) **Abstract**

A photonic device (10) with a longitudinal direction (D) of light propagation comprising:
- a substrate (12),
- a PIN junction (14) comprising an active core (16), an inferior cladding (18) and a superior cladding (20),
wherein the active core (16) is placed in between the inferior cladding (18) and the superior cladding (20) among which one is made of N doped and the other of P doped materials, the active core (16) being tapered along the longitudinal direction (D) in a transition portion (38),
- a regrown layer (26) made of a semi-insulating material and regrown on top of at least part of the inferior cladding (18) and extending vertically on lateral sides of the active core (16) and of the superior cladding (20),
wherein the regrown layer (26) is narrower in the transition portion (38) than in the main portion (34).

## Description

### TECHNICAL FIELD

Various example embodiments relate to optical components, notably to photonic devices. More particularly, a photonic device comprising a III-V structure with a regrown layer and being suitable for edge coupling is disclosed.

### BACKGROUND

Semiconductor based optical components are used in optical networks to emit, modulate and detect light, and to perform some optical processing like amplification, multiplexing, demultiplexing, and demodulation.

Optical coupling of these components to optical fibers is a crucial parameter to limit insertion losses of optical components. However, typical optical components have submicron mode size whereas optical fibers typically have a beam diameter of around 10 µm or 3-5 µm for lensed fibers, thus generating coupling losses between the optical component and the optical fiber.

Obtaining large mode size from optical components is very difficult. With standard solutions, it involves complex design and processing.

Therefore, there is a need for easily manufacturable broadband and large mode photonic devices allowing low coupling losses and wide alignment tolerances to keep assembly cost low.

### SUMMARY

The scope of protection is set out by the independent claims. The embodiments, examples, and features, if any, described in this specification that do not fall under the scope of the protection are to be interpreted as examples useful for understanding the various embodiments or examples that fall under the scope of protection.

According to an aspect, the photonic device with a longitudinal direction of light propagation comprises:
- a substrate,
- a III-V structure above the substrate, the III-V structure being made of III-V materials and comprising a PIN junction and a regrown layer,

wherein the PIN junction comprises an active core, an inferior cladding and a superior cladding,
wherein the active core is placed in between the inferior cladding and the superior cladding among which one is made of N doped and the other of P doped materials, the active core being tapered along the longitudinal direction in a transition portion of the photonic device with respect to a main portion in which the active core has a constant section ,
wherein the regrown layer is made of a semi-insulating material and is regrown on top of at least part of the inferior cladding and extending vertically on lateral sides of the active core and of the superior cladding,
wherein the regrown layer is narrower in the transition portion than in the main portion.

The photonic device may further comprise an interface deposited on the substrate and separating the III-V structure from the substrate, the interface having a high refractive index contrast with respect to the III-V materials.

The transition portion may comprise an extremal end opposite the main portion along the longitudinal direction in which the regrown layer has a constant section.

The active core and the superior cladding may not extend in a distal part of the extremal end.

The transition portion may comprise a proximal end next to the main portion in which the width of the regrown layer decreases gradually.

The inferior cladding may be narrower at least in part of the transition portion than in the main portion.

The inferior cladding may have the same width as the regrown layer in the tip of the extremal end.

The inferior cladding and the regrown layer may form an assembly with a rectangular cross-section in the tip of the extremal end.

The transition portion may comprise an intermediary part between the proximal end and the tip of the extremal end in which the width of the inferior cladding decreases gradually.

The inferior cladding may be made of N type materials and the superior cladding is made of P type materials.

The interface may extend vertically on either side of the regrown layer in the transition portion.

The semi-insulating material of the regrown layer may be Indium Phosphide.

The interface portion may be made of SiO2.

The photonic device may further comprise at least two electrical connection zones among which a first electrical connection in contact with the inferior cladding and a second electrical connection in contact with the superior cladding.

In the extremal end, the regrown layer may form a two stages III-V passive waveguide comprising:
- a first stage corresponding to a lower part of the dual thickness III-V passive waveguide, and
- a second stage on top of the first stage,
and wherein:
- in a first portion of the extremal end, the first stage and the second stage have the same constant width,
- in a second portion, the first stage keeps its constant width, but the second stage is tapered,
- in a fourth portion, the first stage is tapered, and the second stage is not present.

Another embodiment relates to an optical device comprising a photonic device as described above, wherein the optical device is one of a laser, a resonator, an interferometer, a light filter and a light routing device.

According to an aspect, the method of fabrication of a photonic device with a longitudinal direction of light propagation comprises the following steps:
- providing a Si substrate;
- layering the Si substrate with an SiO₂ interface by thermal oxidation of said Si substrate; or depositing an SiO2 interface on the Si substrate;
- providing a III-V structure forming a PIN junction comprising an inferior cladding on which have been layered an etch stop layer, an active core on the inferior cladding and a superior cladding on the active core;
- bonding the III-V structure on the interface in such a way that the inferior cladding is on top of the interface;
- layering a regrown layer made of InP on the inferior cladding;
- etching the regrown layer so that the regrown layer is narrower in the transition portion than in the main portion;
- removing the etch stop layer.

### BRIEF DESCRIPTION OF THE DRAWINGS

Example embodiments will become more fully understood from the detailed description given herein below and the accompanying drawings, which are given by way of illustration only and thus are not limiting of this disclosure.
FIG. 1 schematically represents a vertical cross-section of a device according to a first embodiment;
FIG. 2 is a top view of the photonic device of figure 1,
FIG.3 is a cross-sectional view of the photonic device of figure 2 along section AA;
FIG.4 is a cross-sectional view of the photonic device of figure 2 along section BB;
FIG.5 is a cross-sectional view of the photonic device of figure 2 along section CC;
FIG.6 schematically represents a vertical cross-section of a device according to a second embodiment;
FIG. 7 shows the modes of the light propagating in the extremal end of a device according to an example;
FIG.8 shows the power density as a function of the modes of the light propagating in the extremal end of a device according to an example;
FIG. 9 is a top view of a photonic device according to a third embodiment;
FIG.10 is a cross-sectional view of the photonic device of figure 9 along section AA;
FIG.11 is a cross-sectional view of the photonic device of figure 9 along section BB;
FIG.12 is a cross-sectional view of the photonic device of figure 9 along section CC;
FIG. 13 is a top view of a photonic device according to a fourth embodiment;
FIG.14 is a cross-sectional view of the photonic device of figure 13 along section AA;
FIG.15 is a cross-sectional view of the photonic device of figure 13 along section BB;
FIG.16 is a cross-sectional view of the photonic device of figure 13 along section CC.

It should be noted that these drawings are intended to illustrate various aspects of devices or methods used in example embodiments described herein.

The use of similar or identical reference numbers in the various drawings is intended to indicate the presence of a similar or identical or analogous element or feature.

### DETAILED DESCRIPTION

Detailed example embodiments are disclosed herein. However, specific structural and/or functional details disclosed herein are merely representative for purposes of describing example embodiments and providing a clear understanding of the underlying principles. Thus, these example embodiments may be practiced without these specific details. Moreover, the example embodiments may be embodied in many alternate forms, with various modifications, and should not be construed as limited to only the embodiments set forth herein. In addition, the figures and descriptions may have been simplified to illustrate elements and / or aspects that are relevant for a clear understanding of the present disclosure, while eliminating, for purposes of clarity, many other elements that may be well known in the art or not relevant for the understanding of the disclosure.

In the present description and the claims, the vertical, longitudinal, and transverse orientations according to the reference frame V, L, T shown in the figures, whose longitudinal L and transverse T axes extend in a horizontal plane, will be adopted as nonlimiting and without restrictive reference to terrestrial gravity. By convention, the vertical axis V is oriented from bottom to top.

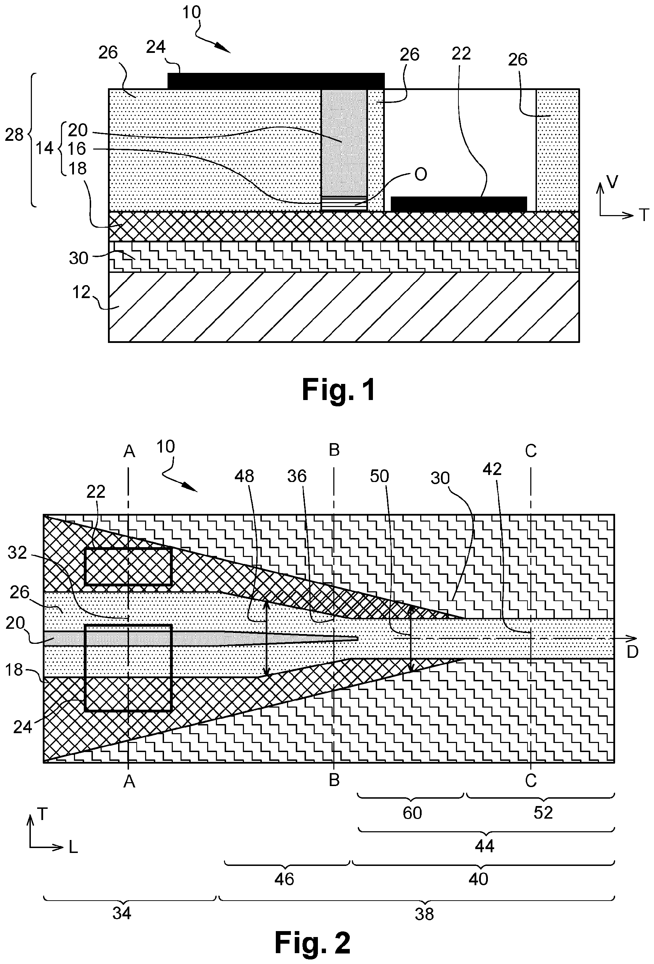

Figure 1 illustrates a photonic device 10 according to a first embodiment. The photonic device 10 allows to obtain highly efficient edge coupling to external components as optical fibers, or other passive components.

In the example, the photonic device 10 comprises a III-V on Silicon Hetero-integrated photonic device. The Hetero-integrated photonic device comprises a substrate, a PIN junction made of III-V materials and a III-V regrown layer. Integration of III-V components on silicon may be used to generate optical gain on low-cost silicon platform.

The photonic device 10 comprises: a substrate 12, an PIN junction 14, a regrown layer 26 and at least two electrical connection zones 22, 24.

The PIN junction 14 is adapted for emitting light O in the case of an emitter or for absorbing light O in the case of a receiver. The PIN junction comprises an active core 16, an inferior cladding 18 and a superior cladding 20. The active core 16 is placed in between or surrounded by an inferior cladding 18 and a superior cladding 20 among which one is made of N type and the other of P type materials. Each cladding is a semiconductor layer stack. The at least two electrical connection zones 22, 24 include a first electrical connection 22 in contact with the inferior cladding 18 and a second electrical connection 24 in contact with the superior cladding 20.

The substrate 12 can be made of silicon (Si). The substrate 12 can also be made of glass or silicon carbide (SiC).

In the example, to form the PIN junction, the inferior cladding is made of N type materials (i.e. N doped materials) and the superior cladding 20 is made of P type materials (i.e. N doped materials). According to a variant, the inferior cladding 18 can be made of P type materials and the superior cladding 20 can be made of N type materials.

In the III-V on Silicon Hetero-integrated photonic platform, a semi-insulating material is regrown around the PIN junction 14 to generate a regrown layer 26. The regrown layer 26 allows to optimize thermal dissipation. The regrowth of semi-insulating material like indium phosphide (InP) on a silicon substrate is a complex technique due to lattice and thermal expansion coefficient mismatch. This is the reason why, traditionally, a simpler technology is used that results in a photonic device comprising a single epitaxial III-V stack.

Regrowing semi-insulating material on a III-V on Silicon Hetero-integrated photonic device is a technique that has been recently developed and described in the patent published under the reference EP2809540. This technique considerably improves performance in terms of heat dissipation of the PIN junction 14.

The regrowth of a semi-insulating material on both sides of the active core 16 and of the superior cladding 20 leads to a buried structure, in which the optical waveguide comprising the PIN junction 14 is buried into regrown semi-insulating material. After regrowth, the regrown layer 26 forms lateral edges of the optical waveguide, while the inferior cladding forms the bottom of the optical waveguide and the superior cladding forms the top of the optical waveguide.

In figure 1, the photonic device 10 comprises a regrown layer 26 made of semi-insulating material on top of at least part of the inferior cladding 18 and extending vertically on either side of the active core 16 and of the superior cladding 20.

Consequently, the photonic device 10 comprises a III-V structure 28 that in this example consists of the PIN junction 14 and the regrown layer 26.

It is particularly interesting to use semi-insulating buried heterostructure (SIBH) in which the regrown semi-insulating material is indium phosphide (InP) since it allows lower optical losses due to low index contrast between the PIN junction 14 and the regrown layer 26 compared to a device having a regrown layer 26 made of a material having a higher index contrast with the PIN junction 14.

For example, the regrown layer 26 can be made of iron (Fe) doped InP, or ruthenium (Ru) doped InP.

In Figure 1, the photonic device 10 comprises an interface 30 deposited on the substrate and having a high refractive index contrast with III-V materials.

The III-V structure made of III-V materials is separated from the substrate 12 by part of the interface 30. Thanks to the high index contrast, the light is confined within the III-V structure.

The inferior cladding 18 is in contact with the interface 30.

For example, the interface 30 is made of silicon dioxide (SiO₂). The refractive index of silicon dioxide is around 1,46 at telecom wavelength whereas the refractive index of III-V materials is generally above 3. For example, the refractive index of InP is around 3,17 at 1,55 µm wavelength. Thus, the interface 30 has a refractive index two times lower than the refractive index of the III-V structure materials.

As a variant, the interface 30 can be made of silicon nitride (SiN) with a refractive index of about 1.8.

In a variant, the substrate 12 can be made of the same material as the interface 30, for example the substrate 12 may be a glass substrate.

The active core 16 is made of at least:
- a AlₓGa_{y}In_{1-x-y}As layer, or
- a GaₓIn₁₋ₓAs_{1-y}P_{y} layer,
with x and y between 0 and 1.

The active core 16 is made of materials different from the materials used in the inferior and superior cladding, for example different from InP used for the layers of the inferior and superior cladding.

The active core 16 can be made of a plurality of layers like a multi quantum wells (MQW) stack. For instance, the MQW stack can consist of:

{ [AlₓGa_{y}In_{1-x-y}As]₁ [AlₓGa_{y}In_{1-x-y}As]₂ }n

with [AlₓGa_{y}In_{1-x-y}As]₁ having a larger bandgap and therefore a lower refractive index than [AlₓGa_{y}In_{1-x-y}As]₂.

The active core 16 can also comprise Gaxln1-xAs1-yPy.

In the example, the inferior cladding 18 is a semiconductor layer stack made of N doped materials. The semiconductor layer stack consists of one or more alloy layers, each alloy being made of materials in the group Al, Ga, In, As, P. The inferior cladding 18 includes for example at least one layer made of InP, GaₓIn₁₋ₓAs_{1-y}P_{y} or AlₓGayIn_{1-x-y}As.

In the example, the superior cladding 20 is a semiconductor layer stack made of P doped materials. The semiconductor layer stack consists of one or more alloy layers, each alloy being made of materials in the group Al, Ga, In, As, P. The superior cladding 18 includes for example at least one layer made of InP, GaₓIn₁₋ₓAs_{1-y}P_{y} or AlₓGayIn_{1-x-y}As. Typically it is at least one InP layer followed by a heavily doped (>1e19 cm-3) InGaAs contact layer.

The first and the second electrical connections can be made of a InGaAs contact layer. The electrical connection in contact with the P doped layer is usually made of InGaAs and the electrical connection in contact with the N dopped layer can be made with any alloy, for example InP or InGaAsP. The electrical connections can comprise a highly doped InP layer. These electrical connections are covered by a metal, not represented here for better lisibility

Figure 2 is a top view of the photonic device 10. For better understanding, the electrical connection zones 22, 24 are not represented on figure 2. Besides, the interface 30 has not been entirely represented.

The photonic device 10 has a longitudinal direction D of light propagation. The photonic device 10 is intended to be coupled to an optical fiber or another optical circuit (for exemple SiN based planar lightwave circuit) at an end located on the right of the figure. Thus, the longitudinal direction D is directed to the right of the figure.

As Figure 2 is a top view of the photonic device 10, the active core 16 is not directly visible. However, the active core 16 has the same horizontal cross section as the superior cladding 20. The active core 16 has a constant section 32 in a main portion 34 of the photonic device 10 and has a tapered section 36 along the longitudinal direction D in a transition portion 38 of the photonic device 10. The transition portion 38 is located to the right of the main portion 34.

The regrown layer 26 is narrower in the transition portion 38 than in the main portion 34. This allows to confine light within the regrown layer 26.

The transition portion 38 comprises an extremal end 40 opposite the main portion 34 along the longitudinal direction D in which the regrown layer 26 has a constant section 42.

The active core 16 and the superior cladding 20 do not extend in a distal part 44 of the extremal end 40.

The transition portion 38 comprises a proximal end 46 next to the main portion 34 in which the width 48 of the regrown layer 26 decreases gradually, for instance substantially linearly.

The inferior cladding 18 has a narrower width 50 at least in part of the transition portion 38 than in the main portion 34.

The inferior cladding 18 has the same width 50 as the regrown layer 26 in the tip 52 of the extremal end 40.

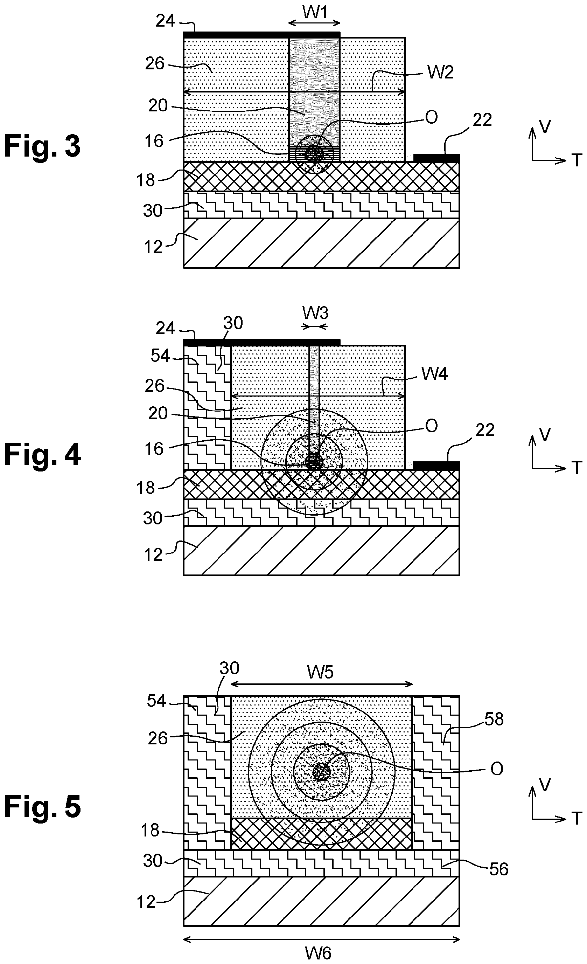

Figure 3 is a cross-sectional view of the photonic device 10 along section AA in Figure 2 showing the main portion 34. In the main portion, the interface 30 covers entirely the substrate 12. The inferior cladding 18 covers entirely the interface 30.

The active core 16 and the superior cladding 20 are superimposed to form an assembly with a rectangular cross-section and are laid approximately in the center of the inferior cladding 18. The active core 16 and the superior cladding 20 have the same width W1. By way of illustration and without limitation, in figure 3, the width W1 is approximately seven times smaller than the inferior cladding's 18 width.

A typical width W1 is between 0.8 to 5 µm with most probable range between 1 and 2 µm.

The active core 16 has a typical thickness of 100 to 600 nm. The active core 16 has a higher refractive index than the inferior cladding 18, and than the superior cladding 20.

In the example, the first electrical connection 22 is a metal plate placed to the right of regrown layer 26 in figure 3 and covering a portion of the inferior cladding 18 of about 10 µm (micrometres).

The regrown layer 26 has been regrown vertically on top of the inferior cladding 18 over a width W2. The regrown layer 26 covers the inferior cladding 18 except for the location of the active core 16 and for the location of the first electrical connection 22. The regrown layer 26 extends on either side of the active core 16 and of the superior cladding 20 over the entire height of the assembly formed by the active core 16 and the superior cladding 20.

The regrown layer 26 can have a thickness of 1 to 4 µm, with most typical value in the range 2-3 µm. The thickness of the regrown layer depends on the thickness of the PIN junction, in particular, the superior cladding 20 thickness.

In the example, the second electrical connection 24 is a plate placed on the top left of the photonic device 10 in figure 3 and covering the left part of the regrown layer 26 and the superior cladding 20.

Figure 4 is a cross-sectional view of the photonic device 10 along section BB in Figure 2 showing the proximal end 46 of the transition portion 38. In the proximal end 46, the interface 30 covers entirely the substrate 12. The inferior cladding 18 covers entirely the interface 30. In another embodiment, on the lateral sides of the regrown layer 26, the device may not comprise an interface 30. Besides, the inferior cladding 18 may extend only under the regrown layer 26 and under the active core 16.

The active core 16 and the superior cladding 20 are superimposed to form an assembly with a rectangular cross-section and are laid, in this example, approximately in the center of the inferior cladding 18. The active core 16 and the superior cladding 20 have the same width W3. The width W3 is smaller than the width W1.

In the proximal end 46, the width W3 is sufficiently thin so that most of the light O is in the regrown layer 26. Typical value of W3 is below 500 nm for efficient coupling and above 100 nm for practical manufacturing. There is no lower limit except technological limit.

In the example, the first electrical connection 22 is a plate placed to the right of the inferior cladding 18 in figure 4 and covering a portion of the inferior cladding 18.

The regrown layer 26 has been regrown vertically on top of the inferior cladding 18 over a width W4. The width W4 is smaller than the width W2. By way of illustration and without limitation, in figure 4, the width W4 is approximately 4/5 of the width W2.

The regrown layer 26 may be centred on the active core 16 and the superior cladding 20.

The regrown layer 26 extends on either side of the active core 16 and of the superior cladding 20 over the entire height of the assembly formed by the active core 16 and the superior cladding 20.

In the example, another portion of the interface 30, the left portion 54, has also been added on top of the inferior cladding 18, on the left of figure 4, where the inferior cladding 30 is not covered by the regrown layer 26, nor by the active core 16, nor by the second electrical connection 22. The left portion 54 of the interface 30 on top of the inferior cladding 18 extends over the entire height of the assembly formed by the active core 16 and the superior cladding 20.

In the example, the second electrical connection 24 is a plate placed on the top left of the photonic device 10 in figure 4 and covers the left portion 54 of the interface 30, the left part of the regrown layer 26 and the superior cladding 20.

Figure 5 is a cross-sectional view of the photonic device 10 along section CC in Figure 2 showing the tip 52 of the extremal end 40. In the tip 52 of the extremal end 40, a lower portion 56 of the interface 30 covers entirely the substrate 12.

In the tip 52 of the extremal end 40, the active core 16 and the superior cladding 20 are not present. The first and the second electrical connections 22, 24 are not present either.

Figure 2 shows that the transition portion 38 comprises an intermediary part 60 between the proximal end 46 and the tip 52 of the extremal end 40 in which the width 50 of the inferior cladding 18 decreases gradually, for instance substantially linearly. In another embodiment, the width 50 of the inferior cladding 18 can decrease in a different way, for example exponentially, according to an arctangent function or to a polynomial function.

In figure 5, the inferior cladding 18 is laid on top of the lower portion 56 of the interface 30. The inferior cladding 18 has a width W5 smaller than the width W6 of the substrate 12 and of the lower portion 56 of the interface 30. The inferior cladding 18 is centered on the lower portion 56 of the interface 30.

In the tip 52 of the extremal end 40, the regrown layer 26 extends on the entire upper surface of the inferior cladding 18 and has the same width W5 as the inferior cladding 18.

A typical width W5 is of 2 to 5 µm.

In figure 5, the inferior cladding 18 and the regrown layer 26 form an assembly with a rectangular cross-section (e.g. square cross-section, or a nearly square cross-section) in the tip 52 of the extremal end 40. For example the cross section may be a 2.5*3 µm cross section. For example the cross section may be a rectangular cross section whose smallest dimension is less than 1.5 times smaller than the longer dimension.

In the tip 52 of the extremal end 40, the interface 30 also extends vertically on either side of the regrown layer 26 and of the inferior cladding 18. The interface 30 comprises the lower portion 56, a left portion 54 on the left of the regrown layer 26 and a right portion 58 on the right of the regrown layer 26. The left portion 54 and the right portion 58 extend over the entire height of the assembly formed by the regrown layer 26 and the inferior cladding 18.

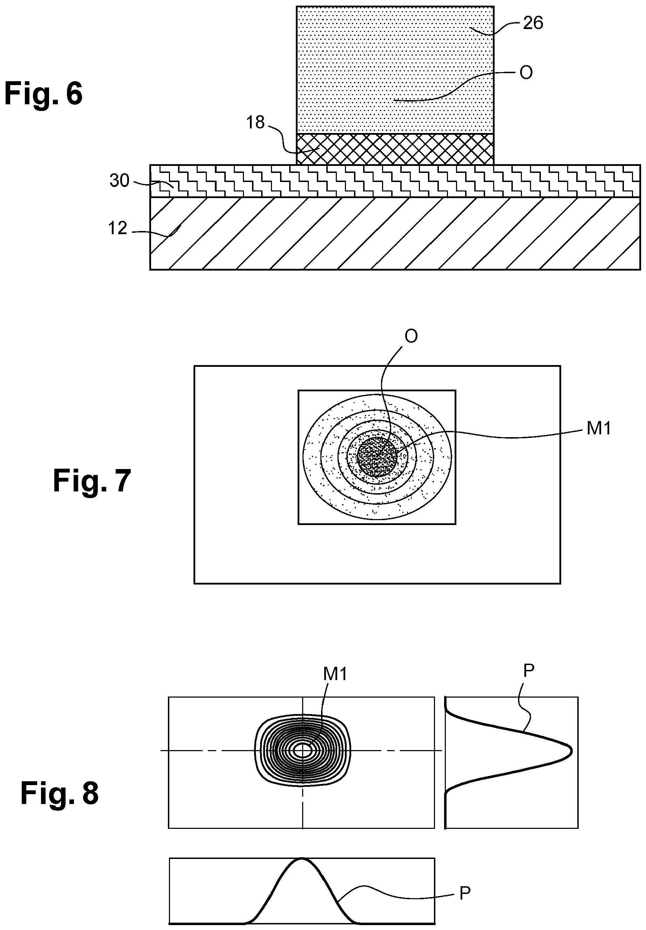

Figure 6 shows a second embodiment in which, in the tip 52 of the extremal end 40, the interface 30 does not extend on either side of the assembly formed by the regrown layer 26 and the inferior cladding 18.

In the tip 52 of the extremal end 40, the assembly formed by the regrown layer 26 and the inferior cladding 18 forms a passive waveguide on the right of the photonic device 10, suitable to perform edge coupling.

Figure 7 shows the circular mode M1 of the light O propagating in the tip 52 of the extremal end 40. The mode M1 has a regular shape, almost circular and have a large diameter, approximately equal to the width W5 of the regrown layer 26. In Figure 8, horizontal and vertical cuts of the mode M1 are shown.

For example, with a 3×3 µm² passive waveguide, a large mode of 2.3×2.4 µm² is obtained, and the passive waveguide can easily be coupled to a lensed fiber.

The absence of the active core 16 and of the superior cladding 20 in the tip 52 of the extremal end 40 avoids the complexity of a long and very thin active waveguide consisting of the active core 16 and of the superior cladding 20. It also avoids competition between the active waveguide and the passive waveguide which allows to have a nicer mode profile.

Figure 8 shows the power density P as a function of the mode M 1. The power density P has a typical shape of a wedge curve and shows no significant losses for any mode.

An advantage of the embodiments described is the possibility to use the large passive waveguide formed by the assembly of the regrown layer 26 and the inferior cladding 18 as a low loss waveguide, which is very interesting for resonators, interferometers, filters, or light routing.

As opposed to most spot size converters used on Silicon photonics platforms, the passive waveguide formed by the assembly of the regrown layer 26 and the inferior cladding 18 has a high index, just slightly lower than the active core 16, which allows an efficient transition between the active core 16 and the passive waveguide.

The photonic device described allows to couple both transverse-electric (TE) and transverse-magnetic (TM) polarization.

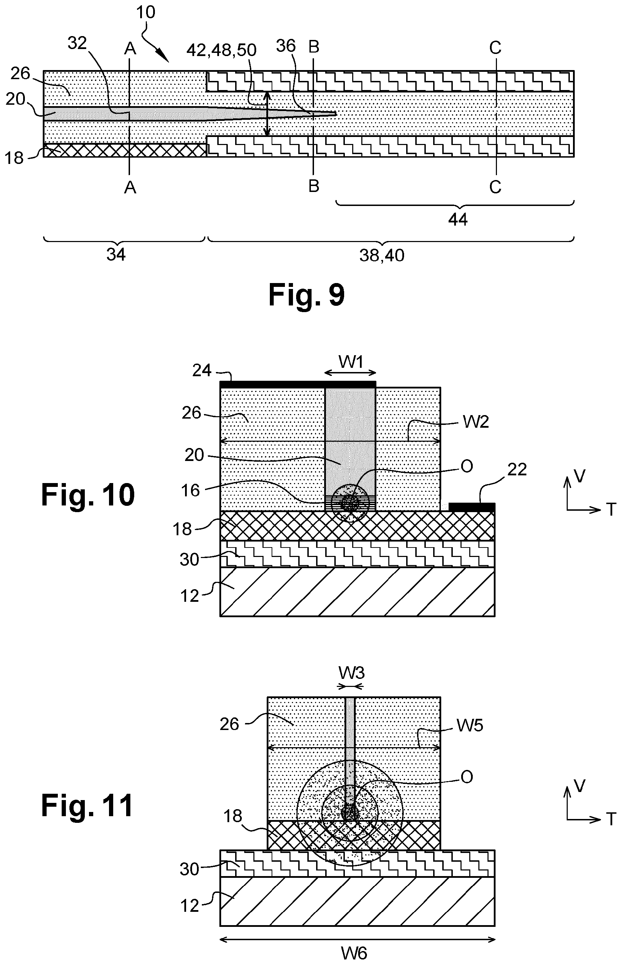

Figure 9 shows a photonic device 10 according to a third embodiment. In the third embodiment, the transition portion 38 does not comprise a proximal end 46 in which the width 48 of the regrown layer 26 decreases gradually, for instance substantially linearly. The regrown layer 26 passes directly from a first width in the main portion 34 to a second width in the transition portion 38.

As Figure 9 is a top view of the photonic device 10, the active core 16 is not directly visible. However, the active core 16 has the same horizontal cross section as the superior cladding 20.

In the third embodiment, the transition portion 38 does not comprise an intermediary part 60 in which the width 50 of the inferior cladding 18 decreases gradually, for instance substantially linearly. The inferior cladding 18 passes directly from a first width in the main portion 34 to a second width in the transition portion 38.

Figure 10 is a cross-sectional view of the photonic device 10 along section AA in Figure 9 showing the main portion 34. The main portion 34 in figure 10 is the same as the main portion 34 in figure 3.

Figure 11 is a cross-sectional view of the photonic device 10 along section BB in Figure 9 showing the transition portion 38 between the main portion 34 and the distal part 44. In this cross-sectional view, similarly to figure 4, the active core 16 and the superior cladding 20 are superimposed to form an assembly with a rectangular cross-section and are laid approximately in the center of the inferior cladding 18. The active core 16 and the superior cladding 20 have the same width W3. The width W3 is smaller than the width W1.

Unlike the first embodiment, the inferior cladding 18 has the same width W5 as the regrown layer 26. There is no electrical connections 22, 24. The interface 30 does not comprise left or right portions on the sides of the regrown layer 26.

In Figure 11, the inferior cladding 18 and the regrown layer 26 form an assembly with a rectangular cross section (e.g. square cross-section, or a nearly square cross-section). For example the cross section may be a 2.5*3 µm cross section. For example the cross section may be a rectangular cross section whose smallest dimension is less than 1.5 times smaller than the longer dimension.

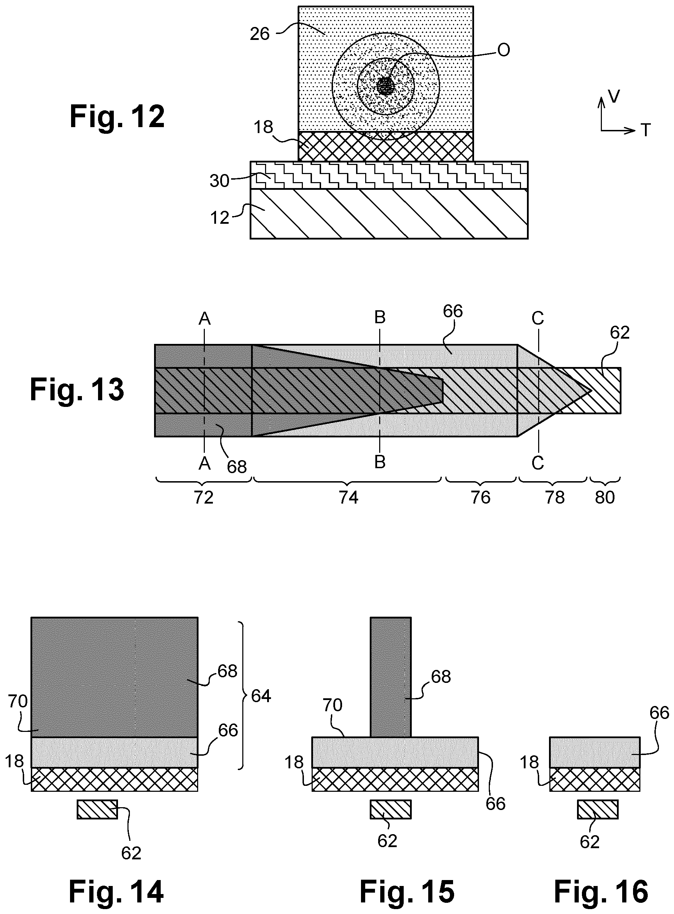

Figure 12 is a cross-sectional view of the photonic device 10 along section CC in Figure 9 showing the tip 52 of the extremal end 40. The tip 52 of the extremal end 40 in figure 12 is the same as the tip 52 in figure 6.

The device 10 does not require coupling to a silicon waveguide in the SiO2 layer which coupling complexifies alignment and is sensitive to the SiO2 bonding thickness.

Figures 13 to 16 show a photonic device 10 according to a fourth embodiment. In this fourth embodiment, the photonic device 10 has a silicon waveguide 62 in the interface 30. The photonic device 10 has an architecture to improve the coupling of the III-V passive waveguide formed by the regrown layer 26, the inferior cladding 18 and the underneath silicon waveguide 62.

The use of a thinner regrown layer 26 improves the coupling between the III-V passive waveguide and the silicon waveguide 62 but reduces the mode size.

To avoid the reduction of the mode size, a dual thickness III-V passive waveguide 64 can be implemented as shown in the fourth embodiment.

Figure 13 is a top view of the photonic device 10 and figure 14, figure 15 and figure 16 are cross-sectional views of the photonic device 10 along respectively section AA, section BB and section CC in Figure 13.

As shown on figure 14, the dual thickness III-V passive waveguide 64 comprises a first stage 66 corresponding to the lower part of the dual thickness III-V passive waveguide 64 and extending vertically on about a fifth of the height of the dual thickness III-V passive waveguide 64.

On top of the first stage 66, the dual thickness III-V passive waveguide 64 comprises a second stage 68 and extending vertically over the rest of the dual thickness III-V passive waveguide 64 height.

On the left of figure 13, in a first portion 72 at section AA level, the first stage 66 and the second stage 68 have the same constant width.

Directly on the right of the first portion 72, in a second portion 74 at section BB level, the first stage 66 keeps its constant width, but the second stage 68 is tapered.

Directly on the right of the second portion 74, in a third portion 76, the first stage 66 keeps its constant width, and the second stage 68 is no more present.

Directly on the right of the third portion 76, in a fourth portion 78 at section CC level, the first stage 66 is tapered, and the second stage is still not present.

Directly on the right of the fourth portion 78 and at the left end of the photonic device 10 in a fifth portion 80, both the first stage 66 and the second stage 68 are not present. Only the silicon waveguide 62 extends in the fifth portion 80.

An etch stop 70 can be used at the interface of the first stage 66 and the second stage 68 to obtain the desired shape of the second stage 68 without etching the first stage 66.

The etch stop 70 is for example a AllnAs layer.

This fourth embodiment allows to have:
- a membrane waveguide on silicon for short bends in the fifth portion 80, and
- a thick waveguide for efficient coupling to an optical fiber in the first portion 72.

The silicon waveguide 62 is optional and can be either removed everywhere or kept only in some predefined parts destinated to have silicon photonic functionality.

The photonic device 10 can be obtained using the following method of fabrication comprising the following steps:
- providing a Si substrate 12;
- layering the Si substrate with an SiO2 interface 30 by thermal oxidation of said Si substrate 12 or depositing a SiO2 interface 30 on the Si substrate 12;
- providing a III-V structure forming a PIN junction comprising an inferior cladding 18 on which have been layered an etch stop layer 70, an active core 16 on the inferior cladding 18 and a superior cladding 20 on the active core 16,
- bonding the III-V structure on the interface 30 in such a way that the inferior cladding 18 is on top of the interface 30,
- etching the superior cladding 20, the active 16 to realize a waveguide;
- layering a regrown layer 26 made of InP on the inferior cladding 18;
- etching the regrown layer 26 so that the regrown layer 26 is narrower in the transition portion 38 than in the main portion 34;
- removing the etch stop layer 70.

Coupling between III-V and silicon as described in the fourth embodiment is very advantageous. Indeed, silicon photonic technology is a growing field within photonics due to its very efficient manufacturing process, based on Complementary Metal Oxide Semiconductor (CMOS). Besides, silicon waveguides can be integrated with low loss. However, no light emission or amplification is possible on silicon, and, for ultimate performances, III-V modulator and photodiode are better than their silicon counterpart. The fourth embodiment allows the integration of III-V components into silicon waveguides.

Several embodiments of a photonic device are disclosed herein. For each of these embodiments, the photonic device may be integrated in:
- a Semi-Insulating Spot Size converter (SI-SSC),
- a semiconductor optical amplifier (SOA),
- a laser, in a resonator,
- an interferometer,
- a light filter, or
- a light routing device.

The terminology used herein is for the purpose of describing particular embodiments only and is not intended to be limiting. As used herein, the singular forms "a," "an," and "the," are intended to include the plural forms as well, unless the context clearly indicates otherwise. It will be further understood that the terms "comprises," "comprising," "includes," and/or "including," when used herein, specify the presence of stated features, integers, steps, operations, elements, and/or components, but do not preclude the presence or addition of one or more other features, integers, steps, operations, elements, components, and/or groups thereof.

While aspects of the present disclosure have been particularly shown and described with reference to the embodiments above, it will be understood by those skilled in the art that various additional embodiments may be contemplated by the modification of the disclosed devices and methods without departing from the scope of what is disclosed. Such embodiments should be understood to fall within the scope of the present disclosure as determined based upon the claims and any equivalents thereof.

### LEGEND

- 10: photonic device
- 12: substrate
- 14: PIN junction
- 16: active core
- 18: inferior cladding
- 20: superior cladding
- 22: first electrical connection
- 24: second electrical connection
- 26: regrown layer
- 28: III-V structure
- 30: interface
- 32: constant section of the active core
- 34: main portion
- 36: tapered section of the active core
- 38: transition portion
- 40: extremal end
- 42: constant section of the regrown layer
- 44: distal part
- 46: proximal end
- 48: width of the regrown layer
- 50: width of the inferior cladding
- 52: tip of the extremal end
- 54: left portion of the interface
- 56: lower portion of the interface
- 58: right portion of the interface
- 60: intermediary part
- 62: silicon waveguide
- 64: dual thickness III-V passive waveguide
- 66: first stage
- 68: second stage
- 70: etch stop
- 72: first portion
- 74: second portion
- 76: third portion
- 78: fourth portion
- 80: fifth portion

### ABBREVIATIONS

SIBH: Semi-Insulating Buried Heterostructure
Si: silicon
InP: Indium Phosphide
Fe: iron
Ru: ruthenium
SiO2: silicon dioxide
SiN: silicon nitride
MQW: multi quantum wells
TE: transverse electic
TM: transverse-magnetic
SI-SSC: Semi-Insulating Spot Size converter
SOA: semiconductor optical amplifier
CMOS: Complementary Metal Oxide Semiconductor

## Claims

1. A photonic device (10) with a longitudinal direction (D) of light propagation comprising:
- a substrate (12),
- a III-V structure (28) above the substrate (12), the III-V structure (28) being made of III-V materials and comprising a PIN junction (14) and a regrown layer (26),
wherein the PIN junction (14) comprises an active core (16), an inferior cladding (18) and a superior cladding (20),
wherein the active core (16) is placed in between the inferior cladding (18) and the superior cladding (20) among which one is made of N doped and the other of P doped materials, the active core (16) being tapered along the longitudinal direction (D) in a transition portion (38) of the photonic device (10) with respect to a main portion (34) in which the active core (16) has a constant section (32),
wherein the regrown layer (26) is made of a semi-insulating material and is regrown on top of at least part of the inferior cladding (18) and extending vertically on lateral sides of the active core (16) and of the superior cladding (20),
wherein the regrown layer (26) is narrower in the transition portion (38) than in the main portion (34).

2. The photonic device (10) according to claim 1, wherein the photonic device (10) further comprises an interface (30) deposited on the substrate (12) and separating the III-V structure (28) from the substrate (12), the interface (30) having a high refractive index contrast with respect to the III-V materials.

3. The photonic device (10) according any one of claim 1 or 2, wherein the transition portion (38) comprises an extremal end (40) opposite the main portion (34) along the longitudinal direction (D) in which the regrown layer (26) has a constant section (42).

4. The photonic device (10) according to claim 3, wherein the active core (16) and the superior cladding (20) do not extend in a distal part (44) of the extremal end (40).

5. The photonic device (10) according to any one of claims 1 to 4, wherein the transition portion (38) comprises a proximal end (46) next to the main portion (34) in which the width (48) of the regrown layer (26) decreases gradually.

6. The photonic device (10) according to any one of claims 1 to 5, wherein the inferior cladding (18) is narrower at least in part of the transition portion (38) than in the main portion (34).

7. The photonic device (10) according to claim 6 combined with claim 3, wherein the inferior cladding (18) has the same width as the regrown layer (26) in the tip (52) of the extremal end (40).

8. The photonic device (10) according to claim 7, wherein the inferior cladding (18) and the regrown layer (26) form an assembly with a rectangular cross-section in the tip (52) of the extremal end (40).

9. The photonic device (10) according to any one of claims 7 or 8, wherein the transition portion (38) comprises an intermediary part (60) between the proximal end (46) and the tip (52) of the extremal end (40) in which the width (50) of the inferior cladding (18) decreases gradually.

10. The photonic device (10) according to any one of claims 1 to 9, in which the inferior cladding (18) is made of N type materials and the superior cladding (20) is made of P type materials.

11. The photonic device (10) according to any one of claims 1 to 10, wherein the interface (30) extends vertically on either side of the regrown layer (26) in the transition portion (38).

12. The photonic device (10) according to any one of claims 1 to 11, wherein the semi-insulating material of the regrown layer (26) is Indium Phosphide (InP).

13. The photonic device (10) according to any one of claims 2 to 12 when combined to claim 2, in which the interface portion (30) is made of SiO2.

14. The photonic device (10) according to any one of claims 1 to 13, further comprising at least two electrical connection zones (22, 24) among which a first electrical connection (22) in contact with the inferior cladding (18) and a second electrical connection (24) in contact with the superior cladding (20).

15. The photonic device (10) according to any one of claims 3 to 14 when combined to claim 3, wherein, in the extremal end (40), the regrown layer (26) forms a two stages III-V passive waveguide (64) comprising:
- a first stage (66) corresponding to a lower part of the dual thickness III-V passive waveguide (64), and
- a second stage (68) on top of the first stage (66),
and wherein:
- in a first portion (72) of the extremal end (40), the first stage (66) and the second stage (68) have the same constant width,
- in a second portion (74), the first stage (66) keeps its constant width, but the second stage (68) is tapered,
- in a fourth portion (78), the first stage (66) is tapered, and the second stage (68) is not present.

16. An optical device comprising a photonic device (10) according to any one of claims 1 to 15, wherein the optical device is one of a laser, a resonator, an interferometer, a light filter and a light routing device.

17. A method of fabrication of a photonic device (10) with a longitudinal direction (D) of light propagation comprising the following steps:
• providing a Si substrate (12);
• layering the Si substrate with an SiO₂ interface (30) by thermal oxidation of said Si substrate (12); or depositing an SiO2 interface (30) on the Si substrate (12);
• providing a III-V structure forming a PIN junction comprising an inferior cladding (18) on which have been layered an etch stop layer (70), an active core (16) on the inferior cladding (18) and a superior cladding (20) on the active core (16);
• bonding the III-V structure on the interface (30) in such a way that the inferior cladding (18) is on top of the interface (30);
• layering a regrown layer (26) made of InP on the inferior cladding (18);
• etching the regrown layer (26) so that the regrown layer (26) is narrower in the transition portion (38) than in the main portion (34);
• removing the etch stop layer (70).
